# EUROPEAN PATENT APPLICATION

(11) **EP 2 190 264 A1**
(43) Date of publication of application: **26.05.2010**
(21) Application number: 08831052.9
(22) Date of filing: 04.09.2008
(51) Int. Cl.: H05B 33/10, C23C 14/12, H01L 51/50

(54) **EVAPORATION APPARATUS**

(30) Priority: 10.09.2007 JP 2007234441; 02.10.2007 JP 2007259099
(71) Applicant: ULVAC, INC., Chigasaki-shi Kanagawa 253-8543 (JP)
(72) Inventor: NEGISHI, Toshio, Chigasaki-shi Kanagawa 253-8543 (JP)
(74) Representative: Körber, Martin Hans
(86) International application number: PCT/JP2008/065982
(87) International publication number: WO 2009/034915

(57) **Abstract**

Contamination of organic EL device is prevented. After a colored layer 85a of the first color is formed, a positioning device 60 moves relatively a substrate 81 and a mask 16 inside the same vacuum chamber 11, and an opening 17 of the mask 16 is moved to a position above the region where a colored layer 85b of the next color is to be formed. As a result, since the colored layers 85a to 85c of two or more colors can be formed without changing the mask 16 and the moving distance of the substrate 81 during deposition becomes short, dust is not generated and contamination of the organic EL device is prevented.

## Description

### Technical Field

The present invention generally relates to a vapor deposition apparatus.

### Background Art

Organic EL element is one of the most watched display elements in recent years and has excellent characteristics of high luminance and high response rate. The organic EL element has a glass substrate on which a light-emitting region is formed in order to develop three different colors: red, green and blue. The light-emitting region is formed by laminating an anode electrode film, a hole-injecting layer, a hole-transporting layer, a light-emitting layer, an electron-transporting layer, an electron-injecting layer, and a cathode electrode film in this order so as to develop color in red, green or blue by the respective coloring agents added to the light-emitting layer.

Each of the hole-transporting layer, the light-emitting layer, the electron-transporting layer, or the like is generally made of an organic material. For the deposition of a film of such an organic material, a vapor deposition apparatus is widely used.

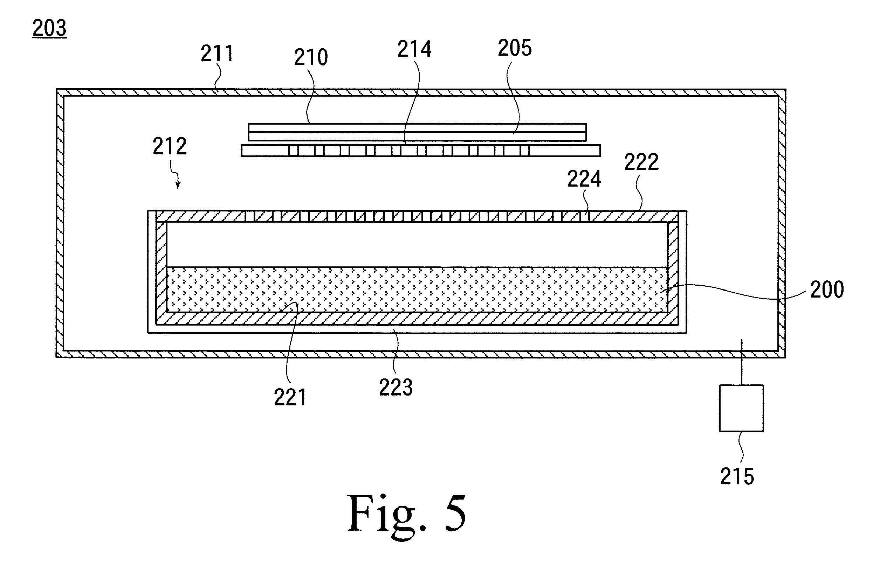

A reference numeral 203 in Fig. 5 denotes a vapor deposition apparatus in the conventional art; and a vapor deposition vessel 212 is disposed inside a vacuum chamber 211. The vapor deposition vessel 212 has a vessel body 221; and the upper portion of the vessel body 221 is closed by a lid part 222 having one or more emission holes 224 formed therein.

Inside the vapor deposition vessel 212, a powder organic vapor deposition material 200 is disposed.

A heating means 223 is located at side faces and a bottom face of the vapor deposition vessel 212. When the vacuum chamber 211 is evacuated and the heating means 223 generates heat, the vapor deposition vessel 212 increases the temperature thereof; and thus, the organic vapor deposition material 200 in the vapor deposition vessel 212 is heated.

When the organic vapor deposition material 200 is heated to at or above the evaporation temperature thereof, the vapor deposition vessel 212 is filled with the vapor of the organic material, and the vapor is emitted into the vacuum chamber 211 via the emission holes 224.

A holder 210 is provided above the emission holes 224. When a substrate 205 is held by the holder 210, the organic material vapor emitted from the emission holes 224 reaches the surface of the substrate 205, thereby forming an organic thin film such as a hole-injecting layer, a hole-transporting layer, and a light-emitting layer thereon.

For manufacturing a color display organic EL device, normally the light-emitting layer is formed by depositing the respective colored layers of two or more colors in the respective different regions. In this case, since the colored layer is to be formed in the respective predetermined regions, the deposition is performed after disposing, between the vapor deposition vessel 212 and the substrate 205, a mask 214 having openings which have almost the same shape and spacing as those of the regions.

In the conventional art, after the film formation of the first color of the colored layer is completed, the mask 214 is removed from the substrate 205. Then the substrate 205 is transported to a different vapor deposition apparatus, where a new mask is attached, and the film of the second color or more of the colored layer is formed.

However, since, in the above-described method, during a period of depositing a single light-emitting layer, the substrate 205 has to be carried-in to and carried-out from the vapor deposition apparatus several times and the transportation distance of the substrate 205 increases, which results in dust likely to be generated. Once dust is generated, the dust enters the light-emitting layer and the thin film deposited in the succeeding step of forming the light-emitting layer, which causes contamination of the organic EL device.
Patent Document 1: Japanese Patent Laid-OpenNo. 10-204624
Patent Document 2: Japanese Patent Laid-Open No. 2006-307239
Patent Document 3: Japanese Patent Laid-Open No. 2003-293121
Patent Document 3: Japanese Patent Laid-Open No. 2005-163156

### Disclosure of the Invention

### Problems to be Solved by the Invention

The present invention is directed to solve the above problems, and an object of the present invention is to provide a vapor deposition apparatus which enables the formation of a film of a light-emitting layer without causing contamination.

### Means for Solving the Problems

In order to solve the above problems, the present invention is directed to a vapor deposition apparatus having a vacuum chamber, a substrate-holding device located inside the vacuum chamber for holding a substrate, a feeding device containing an organic material therein for generating a vapor of the organic material, an emitting device located at a position facing the substrate for emitting, to the inside of the vacuum chamber, the vapor of the organic material which is generated from the feeding device, a mask having a plurality of openings formed therein and located inside the vacuum chamber, and a mask-holding device holding the mask at a position between the substrate and the emitting device. The present invention is directed to the vapor deposition apparatus, in which the vapor emitted from the emitting device passes through the openings of the mask and reaches the substrate having each of a plurality of the feeding devices connected to the emitting device, a positioning device for positioning the substrate held by the substrate-holding device with the mask held by the mask-holding device, and a switching device for connecting the desired feeding device among a plurality of the feeding devices to the emitting device.

The present invention also provides a vapor deposition apparatus having a vacuum chamber, a substrate-holding device located inside the vacuum chamber for holding a substrate, a feeding device containing an organic material therein for generating a vapor of the organic material, and an emitting device located at a position facing the substrate for emitting , to the inside of the vacuum chamber, the vapor of the organic material which is generated from the feeding device. The vapor deposition apparatus, in which the vapor emitted from the emitting device reaches the substrate, further includes each of a plurality of the feeding devices connected to the emitting device, and a switching device for connecting the desired feeding device among a plurality of the feeding devices to the emitting device.

The present invention further provides a vapor deposition apparatus, wherein the respective feeding devices contain the organic material having a color different from each other.

The present invention still further provides a vapor deposition apparatus, in which each of the feeding devices includes a containing part containing the organic material, a through-hole formed at a bottom part of the containing part, an evaporation chamber connected to the containing part via the through-hole, a rotary shaft inserted into the through-hole, and a rotary means for rotating the rotary shaft around a center axis thereof, and wherein the rotary shaft has a spiral convex portion formed at the periphery thereof, and the rotation of the rotary shaft moves the organic material from the containing part toward the evaporation chamber through a groove between the convex portions.

### Effect of the Invention

Without carrying in and carrying out the substrate to and from the vacuum chamber, the different organic thin films can be formed at different places on the substrate within the same vacuum chamber. Compared to the conventional art, the transport distance of the substrate during deposition is small so that no dust is generated inside the vacuum chamber, which causes no contamination in the organic EL device.

### Brief Description of the Drawings

Fig. 1 shows a schematic plan view illustrating an example of a film-forming apparatus.
Figs. 2 (a) to 2 (b) show cross sectional views illustrating the process of depositing colored layers.
Fig. 3 shows a schematic perspective view of a vapor deposition apparatus of the present invention.
Fig. 4 shows a cross-sectional view of the vapor deposition apparatus of the present invention.
Fig. 5 shows a cross-sectional view illustrating a vapor deposition apparatus of the conventional art.

### Explanation of Reference Numerals

- 10a to 10c: vapor deposition apparatus
- 11: vacuum chamber
- 15: substrate-holding device
- 16: mask
- 20a to 20c: feeding device
- 39: organic material
- 50: emitting device
- 60: positioning device

### Best Modes for Carrying Out the Invention

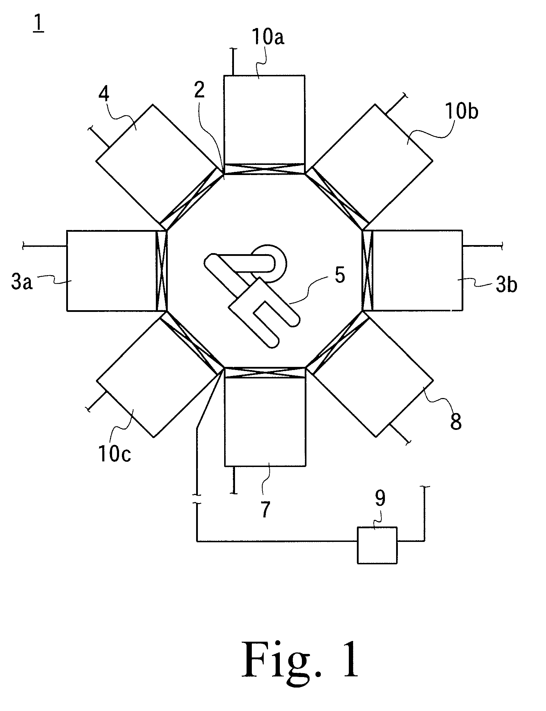

A reference symbol 1 in Fig. 1 shows an example of a film-forming apparatus.

The film-forming apparatus 1 has a transporting chamber 2. A carry-in chamber 3a, a carry-out chamber 3b, a pretreatment chamber 4, one or more vapor deposition apparatuses 10a to 10c, a sputtering apparatus 8, and a mask-storing chamber 7, respectively, are connected to the transporting chamber 2.

A transfer robot 5 is positioned inside the transporting chamber 2. An evacuation system 9 forms a vacuum atmosphere inside of each of the transporting chamber 2, the carry-in chamber 3a, the carry-out chamber 3b, the pretreatment chamber 4, the vapor deposition apparatuses 10a to 10c, and the sputtering apparatus 8. The substrate carried into the carry-in chamber 3a is transported by the transfer robot 5 from the carry-in chamber 3a to the pretreatment chamber 4 in the vacuum atmosphere to undergo the pretreatment of cleaning, heating, or the like. After that, the substrate is transported through each of the vapor deposition apparatuses 10a to 10c successively, and organic thin films, such as a charge transfer layer, a light-emitting layer, and an electron transfer layer, are laminated on the substrate. Then, an upper electrode film is formed on the organic thin film by the sputtering apparatus 8. Finally the substrate is carried out from the carry-out chamber 3b.

Among the organic thin films, the light-emitting layer is composed of colored layers having two or more different colors being respectively formed at the corresponding regions on the surface of the substrate.

A reference symbol 10b in Fig. 1 denotes a vapor deposition apparatus of the present invention used for depositing the light-emitting layer.

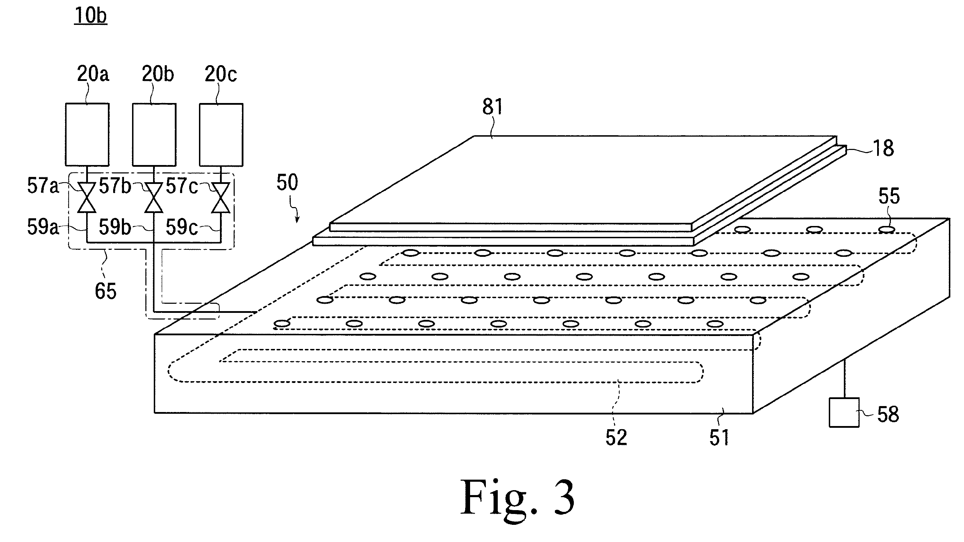

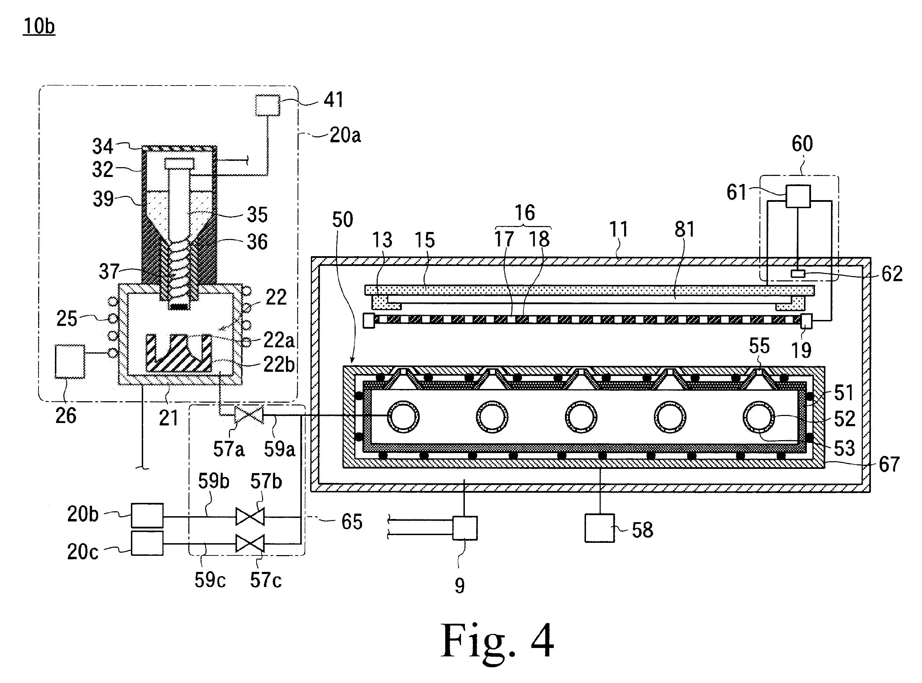

Fig. 3 shows a perspective view of the vapor deposition apparatus 10b; and Fig. 4 shows a cross sectional view of the vapor deposition apparatus 10b. The vapor deposition apparatus 10b has a vacuum chamber 11, a substrate-holding device (substrate holder) 15, a mask-holding device 19, a positioning device 60, an emitting device 50, a switching device 65, and a plurality of feeding devices 20a to 20c (3 units in this embodiment).

The vapor deposition material in this embodiment is an organic material composed of a mixture of an organic compound (host) as a main component and a coloring agent (dopant) as an additive. The respective feeding devices 20a to 20c contain the organic materials having the same colors as those of the colored layer (red, green and blue in this embodiment). These feeding devices 20a to 20c have the same structure, except that colors of organic materials 39 are different. The description below is given by designating the same reference symbol to the same member.

Each of the feeding devices 20a to 20c has a vessel-shape containing part 32, and a lid 34 is attached at the opening of the vessel. The organic materials 39 are respectively contained in each of the containing parts 32.

The bottom portion of the containing part 32 is in a mortar shape. At approximately center of the bottom of the mortar shape, a through-hole 37 is formed, and the containing part 32 is connected to an evaporation chamber 21 via the through-hole 37.

A rotary shaft 35, which has a spiral convex portion 36 around thereof, is inserted into the through-hole 37. When a rotary means 41 rotates the rotary shaft 35 around the center axis thereof, the organicmaterial 39 contained in the containing part 32 moves from the top toward the bottom of the through-hole 37 therein via the groove between the convex portions 36. Once the organic material 39 reaches the lower end of the through-hole 37, the organic material 39 drops off from the groove immediately below into the evaporation chamber 21.

Since the amount of dropping organic material 39 is proportionate to the number of rotations of the rotary shaft 35, if the relationship between the amount of drop and the number of rotations is preliminarily determined, the number of rotations required for dropping the necessary amount of the organic material 39 is predicted from the relationship thereof.

A hot body 22 is arranged directly beneath the through-hole 37 in the evaporation chamber 21.

The hot body 22 has a high temperature vessel 22b having an opening larger than the bottom opening of the through-hole 37, and a convex part 22a provided approximately at the center of the bottom of the high temperature vessel 22b.

The area of the cross-section of the convex part 22a is almost equal to that of the cross section of the rotary shaft 35; and the convex part 22a is positioned at directly beneath the rotary shaft 35.

Accordingly, the vapor deposition material 39 dropping directly underneath the lower end of the through-hole 37 comes between the convex part 22a and the side wall of the high temperature vessel 22b, so as to surround the convex part 22a resulting from the rotation of the rotary shaft 35.

A heating means (such as a coil) 25 is wound around the evaporation chamber 21. If an electric power is preliminarily applied to the heating means 25 from a power source 26 and the hot body 22 is induction-heated inside the evaporation chamber 21, the organic material is heated by the hot body 22, and the vapor thereof is generated.

As described above, since the vapor deposition material 39 is placed between the convex part 22a and the side wall of the high temperature vessel 22b so as to surround the convex part 22a, the vapor deposition material 39 is uniformly heated, and the vapor of the vapor deposition material 39 is generated in the evaporation chamber 21.

Each of the feeding devices 20a to 20c is connected to the switching device 65, and the vapor generated in the evaporation chambers 21 is supplied to the switching device 65.

The switching device 65 has a plurality of pipes 59 and valves 57. Each of the pipes 59 is connected to an evaporation chamber 21 of each of the feeding devices 20a to 20c at an end thereof, while the other end of the pipe 59 is connected to the single emitting device 50, and each of the valves 57 is attached between an end and the other end of each of the pipes 59a to 59c.

The vapor supplied to the switching device 65 is fed to the pipes 59a to 59c connected to the vapor-generated evaporation chamber 21. When the valves 57a to 57c which are attached to the pipes 59a to 59c are opened, the vapor is supplied into the emitting device 50. On the other hand, when the valves 57a to 57c are closed, the vapor is not supplied to the emitting device 50.

The emitting device 50 has a box-shaped vessel 51 and supply pipes 52 arranged in the vessel 51. The vapor supplied to the emitting device 50 is fed to the supply pipes 52, and is ejected toward the bottom of the vessel 51 from ejection holes 53 provided on the supply pipes 52, and is then emitted inside the vacuum chamber 11 from emission holes 55 provided at the ceiling of the vessel 51.

Next, the step of depositing the light-emitting layer using the vapor deposition apparatus 10b is described.

The vacuum chamber 11, the evaporation chambers 21, and the containing parts 32 are connected to the evacuation system 9; and the internal spaces of the vacuum chamber 11, the evaporation chambers 21, and the containing parts 32 sealed in a state of containing the organic material 39 are evacuated to form a vacuum atmosphere in the internal spaces of the evaporation chambers 21, the vacuum chamber 11, the vessel 51, the supply pipes 52, the pipes 59, and the containing parts 32 at a predetermined pressure (for example, 10⁻⁵Pa). A substrate 81 is carried-in to the vacuum chamber 11 while maintaining the vacuum atmosphere.

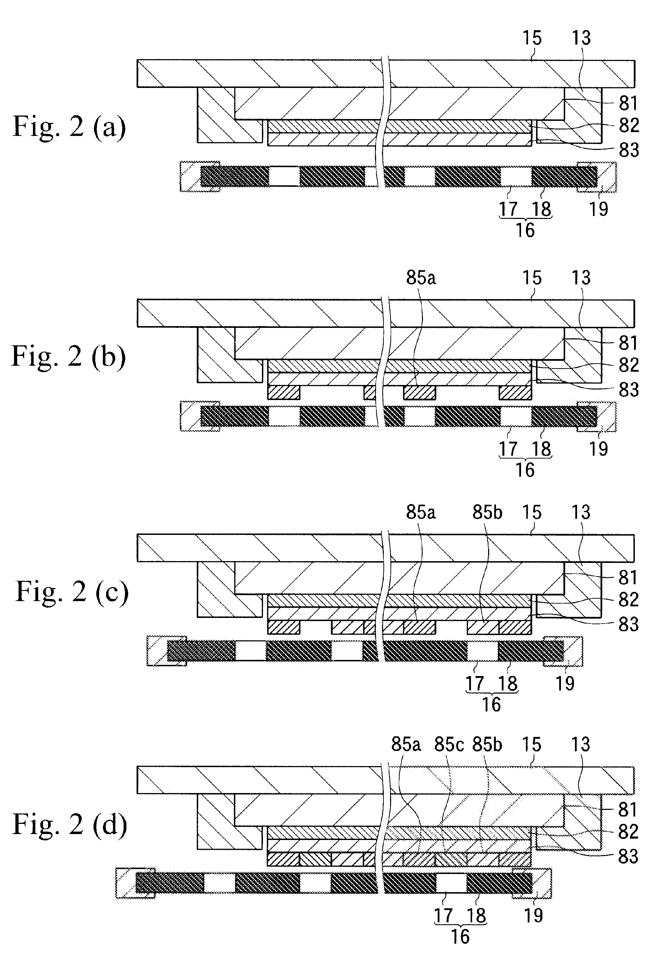

Fig. 2 (a) shows a cross-sectional view of the substrate 81, which is carried into the vacuum chamber 11. Before the substrate 81 is carried into the film-forming apparatus 1, a transparent electrode 82 is formed on the surface thereof; and in another vapor deposition apparatus 10a, an organic thin film 83, such as a charge transporting layer and a charge-injection layer, is preliminarily formed.

A substrate-holding device 15 and a mask-holding device 19 are arranged inside the vacuum chamber 11. The substrate-holding device 15 holds the substrate 81, which is carried into the vacuum chamber 11, in such a manner that the deposited side of the substrate on which the transparent electrode 82 and the organic thin film 83 are formed is faced downward.

The mask 16 has a plate-shaped shield part 18 and a plurality of openings 17 provided on the shield part 18. The mask 16 is carried into the vacuum chamber 11 in advance, and is held by the mask-holding device 19 in such a manner that the openings 17 are exposed.

The mask 16 used in the present invention is the one to be used for forming colored layers of two or more colors by the single sheet of mask 16.

The shape and the spacing of regions to form the respective colored layers of the respective colors on the substrate 81 are equal with each region; and the shape and the spacing of the openings 17 of the mask 16 are almost equal to the shape and the spacing of regions to form the respective colored layers of the respective colors.

A positioning device 60 has a transport means 61 and a monitor (such as a CCD camera) 62. The sequential order of color of colored layers to be deposited is preliminarily determined. While the monitor 62 monitors the alignment mark of the mask 16 and the alignment mark of the substrate 81, the transport means 61 moves any one or both of the substrate-holding device 15 and the mask-holding device 19 to align the positioning of the respective openings 17 to the respective regions where the colored layer of the first color is formed on the surface of the substrate 81.

When the substrate 81 and the mask 16, which are aligned with each other, are maintained in a relatively stand still state, the substrate 81 held by the substrate-holding device 15 is brought to a position above the emitting device 50, and the mask 16 held by the mask-holding device 19 is then brought to a position between the emitting device 50 and the substrate 81.

The valves 57a to 57c are kept closed. The hot body 22 of each of the feeding devices 20a to 20c is heated to a predetermined temperature (for example, 300°C to 350°C), and the temperature is then maintained.

The film thickness of each colored layer is preliminarily determined, and the amount of organic material 39 necessary to deposit the colored layer with the predetermined thickness is preliminarily grasped.

When the respective valves 57a to 57c are closed and the vacuum chamber 11 is evacuated, the valve of the evacuation system connected to the evaporation chamber 21 of the feeding device 20a for the first color is closed; the rotary shaft 35 is rotated by a necessary number of rotations; the necessary amount of the organic material 39 of the first color is dropped onto the hot body 22; and the vapor is generated in the evaporation chamber 21.

When the internal pressure of the evaporation chamber 21 reaches a predetermined pressure, the evacuation of the vacuum chamber 11 is continued while the valve of evacuation system connected to the evaporation chamber 21 is kept closed. Thus, while other evaporation chambers 21 are shut-off from the emitting device 50, only the evaporation chamber 21 where the vapor of the first color is generated is connected to the emitting device 50. Using difference in pressure, the vapor is brought to pass through the switching device 65 and the emitting device 50, and is emitted into the vacuum chamber 11 via the emission holes 55.

In this step, since the evaporation chambers 21 generating vapors of other colors are shut-off from the emitting device 50, the vapors are not mixed with each other, and only the vapor of the first color passes through the openings 17 of the mask 16. As a result, as illustrated in Fig. 2(b), a colored layer 85a of the first color is formed on predetermined regions.

When a predetermined period of time has passed from dropping the organic material 39 of the first color onto the hot body 22, or when the internal pressure of the evaporation chamber 21 which generates the vapor of the organic material 39 of the first color reaches or is below the predetermined pressure, the deposition of the colored layer 85a of the first color is judged to be completed.

After completing the deposition of the colored layer 85a of the first color, the evaporation chamber 21 which generated the vapor of the first color is evacuated in a state of closing the valve 57a while continuing the evacuation of the vacuum chamber 11. Then, the evacuation of the vacuum chamber 11 discharges the vapor of the first color from the emitting device 50 and from the switching device 65 at a portion of the emitting device 50 side, not at the portions of the valves 57a to 57c sides, and the evacuation of the evaporation chamber 21 discharges the vapor of the first color from the evaporation chamber 21 and from the switching device 65 at a portion of the evaporation chamber 21 side, not at the portions of the valves 57a to 57c sides.

When the vacuum atmospheres in the vacuum chamber 11, the emitting device 50, the switching device 65, and the evaporation chambers 21 are formed at respectively predetermined pressure, the vapor of the color of the organic material 39 is generated in the evaporation chamber 21 of the feeding device 20b containing the organic material 39 of the second color while the respective valves 57a to 57c are kept closed.

The openings 17 of the mask 16 are moved from the regions to form the colored layer of the first color on the surface of the substrate 81 to the regions to form the colored layer of the second color thereon. Then, the evaporation chamber 21 which generated the vapor of the organic material 39 of the second color is connected to the emitting device 50. As illustrated in Fig. 2(c), a colored layer 85b of the second color are deposited at the regions in order to form the colored layer 85b.

After the deposition of the colored layer 85b of the second color is completed, by repeating the discharge of vapor, the positioning, and the deposition of colored layer, a colored layer 85c of the three or more colors can be formed on the respective predetermined regions on the surface of the substrate 81 (Fig. 2(d)).

According to the present invention, since the colored layers 85a to 85c of two or more colors are formed by changing the positions of the single sheet of the mask 16, the number of the openings 17 is larger than the number of the colored layers of a single color. Thus, the opening 17 at an edge part of the mask 16 may go into an unnecessary region so as to form the colored layer on the substrate 81.

In this embodiment, a frame 13 is applied to the outer peripheral part of the substrate 81 held by the substrate-holding device 15, and the regions unnecessary to form the colored layer are covered with the frame 13. Accordingly, the vapor does not reach the regions unnecessary to form the colored layer, and the colored layers 85a to 85c are formed only in the predetermined regions.

The above description is given to the case where the host and the dopant are contained in the same containing part 32 of each of the feeding devices 20a to 20c. The present invention is, however, not limited thereto.

For example, it may be that the host and the dopant are contained in different containing parts 32 of the feeding devices 20a to 20c, respectively; each of the vapor of host and the vapor of dopant is supplied to the same supply pipe 52 from the feeding device 20a containing the host and from the feeding device 20b containing the dopant; the mixed vapor of the host vapor and the dopant vapor is emitted from the emission holes 55; and then an organic thin film containing both the host and the dopant is deposited.

The colored layers 85a to 85c are not limited to three colors, and a single color or four or more colors can be applied.

When any one or both of the emitting device 50 and the substrate-holding device 15 are connected to a shaker 58, and any one or both of the emitting device 50 and the substrate-holding device 15 reciprocate or circulate in horizontal plane, in such a state that the substrate 81 and the mask 16 stand still relative to each other, during the period of growth of the colored layer 85a, then the film thickness of the colored layer 85a becomes uniform.

The direction of relative reciprocating motion of the substrate 81 and the emitting device 50 is not specifically limited. However, for example, when the supply pipe 52 has a plurality of branch pipes arranged at a predetermined spacing therebetween, the substrate 81 and the emitting device 50 are moved relatively in the direction intersecting the branch pipes in the horizontal plane.

If a cooling plate 67 is positioned around the vessel 51 with a distance therebetween, the mask 16 is not heated so that the thermal expansion of the mask 16 does not occur, thereby increasing the deposition accuracy of the colored layers 85a to 85c.

If openings are formed on the cooling plate 67 at the positions above the emission holes 55 so as to expose the emission holes 55 and the area of the opening of the cooling plate 67 is sufficiently large to avoid contact with vapor emitted from the emission hole 55, the vapor is not deposited on the cooling plate 67.

The heating of the hot body 22 is not limited to induction heating, and thermal conduction from a heating means may be used. Furthermore, the organic material 39 may be directly heated by irradiating laser beam to the organic material 39.

Alternatively, the inside of the evaporation chambers 21 may be evacuated, not by connecting the evaporation chambers 21 directly to the evacuation system, but by connecting the evaporation chambers 21 to the emitting device 50 and evacuating the vacuum chamber 11. In this case, the evacuation of the evaporation chamber 21 can be stopped by shutting-off the evaporation chambers 21 from the emitting device 50 by using the switching device 65.

The shape and the installation place of the hot body 22 are not specifically limited, and the hot body 22 may be placed obliquely downwardly below the through-hole 37 if only the organic material can enter the hot body 22.

In addition, the present invention is not limited to the case of using the mask 16. For example, it may be that the mask is not placed between the substrate 81 and the emitting device 50, and the colored layers 85a to 85c of three or more colors may be laminated on the surface of the substrate 81 in order to form an organic film for white light.

## Claims

1. A vapor deposition apparatus having a vacuum chamber, a substrate-holding device located inside the vacuum chamber for holding a substrate, a feeding device containing an organic material therein for generating a vapor of the organic material, an emitting device located at a position facing the substrate for emitting, to the inside of the vacuum chamber, the vapor of the organic material which is generated from the feeding device, a mask having a plurality of openings formed therein and located inside the vacuum chamber, and a mask-holding device holding the mask at a position between the substrate and the emitting device, the vapor deposition apparatus in which the vapor emitted from the emitting device passes through the openings of the mask and reaches the substrate, **characterized by** each of a plurality of the feeding devices connected to the emitting device, a positioning device for positioning the substrate held by the substrate-holding device with the mask held by the mask-holding device, and a switching device for connecting the desired feeding device among a plurality of the feeding devices to the emitting device.

2. The vapor deposition apparatus according to claim 1, **characterized in that** the respective feeding devices contain the organic material having a color different from each other.

3. The vapor deposition apparatus according to claim 1, **characterized in that** each of the feeding devices has a containing part containing the organic material, a through-hole formed at a bottom part of the containing part, an evaporation chamber connected to the containing part via the through-hole, a rotary shaft inserted into the through-hole, and a rotary means for rotating the rotary shaft around a center axis thereof, wherein the rotary shaft has a spiral convex portion formed at the periphery thereof, and the rotation of the rotary shaft moves the organic material from the containing part toward the evaporation chamber through a groove between the convex portions.

4. A vapor deposition apparatus having a vacuum chamber, a substrate-holding device located inside the vacuum chamber for holding a substrate, a feeding device containing an organic material therein for generating a vapor of the organic material, and an emitting device located at a position facing the substrate for emitting, to the inside of the vacuum chamber, the vapor of the organic material which is generated from the feeding device, the vapor deposition apparatus, in which the vapor emitted from the emitting device reaches the substrate, **characterized by** each of a plurality of the feeding devices connected to the emitting device, and a switching device for connecting the desired feeding device among a plurality of the feeding devices to the emitting device.

5. The vapor deposition apparatus according to claim 4, **characterized in that** the respective feeding devices contain the organic material having a color different from each other.

6. The vapor deposition apparatus according to claim 4, **characterized in that** each of the feeding devices has a containing part containing the organic material, a through-hole formed at a bottom part of the containing part, an evaporation chamber connected to the containing part via the through-hole, a rotary shaft inserted into the through-hole, and a rotary means for rotating the rotary shaft around a center axis thereof, wherein the rotary shaft has a spiral convex portion formed at the periphery thereof, and the rotation of the rotary shaft moves the organic material from the containing part toward the evaporation chamber through a groove between the convex portions.
